# FASCICULE DE BREVET EUROPEEN

(11) **EP 0 575 247 B1**
(45) Date de publication et mention de la délivrance du brevet: **11.11.1998**
(21) Numéro de dépôt: 93401540.5
(22) Date de dépôt: 16.06.1993
(51) Int. Cl.: H01L 29/737, H01L 21/331, H01L 29/205

(54) **Procédé de réalisation de transistor bipolaire à hétérojonction et transistor obtenu**
Verfahren zur Herstellung eines bipolaren Heteroübergangstransistors und so erhaltener Transistor
Method of manufacturing a bipolar heterojunction transistor and transistor obtained by this method

(30) Priorité: 17.06.1992 FR 9207354
(43) Date de publication de la demande: 22.12.1993
(73) Titulaire: FRANCE TELECOM, 75015 Paris (FR)
(72) Inventeur: Dubon-Chevallier, Chantal, F-92320 Chatillon (FR); Dangla, Jean, F-91940 les Ulis (FR); Benchimol, Jean-Louis, F-91120 Palaiseau (FR); Alexandre, François, F-94400 Vitry-sur-Seine (FR)
(74) Mandataire: Martin, Jean-Jacques

(56) Documents cités:
- EP-A- 408 252
- ELECTRONICS LETTERS vol. 25, no. 17, 17 Août 1989, STEVENAGE, GREAT BRITAIN pages 1175 - 1177 R.J. MALIK ET AL *
- ELECTRONICS LETTERS vol. 28, no. 3, 30 Janvier 1992, STEVENAGE, GREAT BRITAIN pages 327 - 328 P. ZWICKNAGL ET AL. *
- IEEE ELECTRON DEVICE LETTERS vol. EDL-7, no. 2, Février 1986, NEW YORK USA pages 129 - 131 J.L. LIEVIN ET AL. *
- IEEE TRANS ON ELECTRON DEVICES, ED-34, No 2, Février 1987, page 185, S.TIWARI ET AL
- EL. LETTERS, VOL 15 (3) 1979, page 90, A.CHANDRA ET AL
- J.APPL PHYS, vol 65 (6), 1989, page 2530, T.J.DE LYON
- JAP J. APPL PHYS., vol 24 (8) 1985, page l611, H.ITO
- THESE, 1980, A.MARTY
- IEEE TRANS EL DEV, vol 26 (10) 1989, p 2032, P.M.ASBACH ET AL

## Description

La présente invention concerne le domaine de la conception des transistors.

La présente invention s'applique en particulier à la réalisation de transistors bipolaires à hétérojonction.

Le principe de fonctionnement des transistors bipolaires à hétérojonction, ainsi que leurs principaux domaines d'application, sont bien connus de l'homme de l'art. Ces principes de fonctionnement et domaines d'application ont fait l'objet d'un abondante littérature. On peut par exemple se référer aux documents suivants : 1) "Heterostructure Bipolar Transistors and integrated circuits", H. Kroemer, Proc. IEEE, 25 (1), Janv. 1982; 2) "GaAlAs/GaAs Heterojunction Bipolar Transistors : issues and prospects for applications" P. Asbeck, M. Chang, J. Higgins, N. Sheng, G. Sullivan, K. Wang, IEEE Trans. Electron. Dev. 36 (10), Oct. 1989; 3) "GaAs Heterojunction Bipolar Transistor device and IC fabrication technology for high performance analog and microwave applications", M. Kim, A.Oki, G. Gorman, D. Umemoto, J. Camou, Trans. Microwave Theory Tech., 37 (9), Sept. 1989.

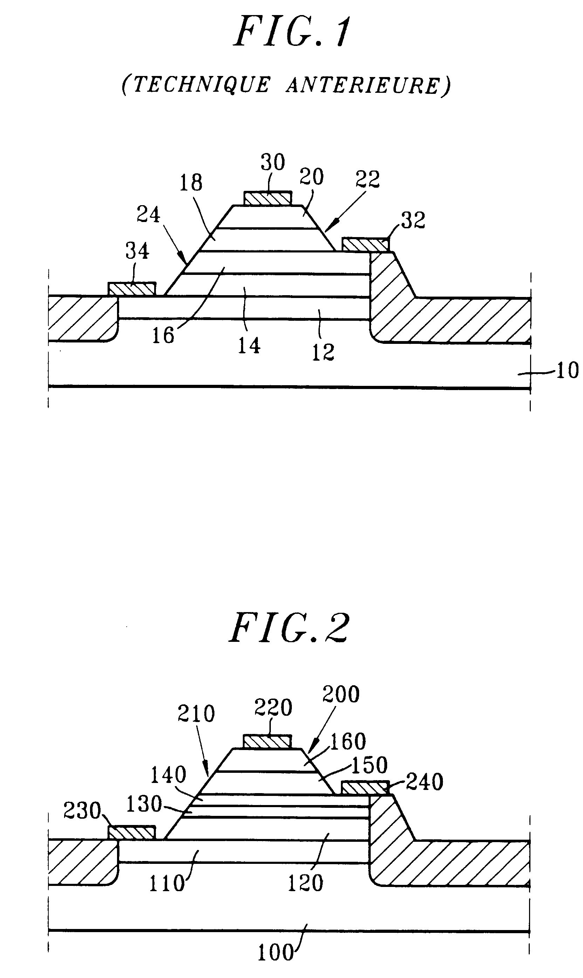

Les structures classiques de transistors bipolaires à hétérojonction comprennent généralement, comme représenté sur la figure 1 annexée, un substrat semi-isolant 10, une couche de contact collecteur 12 en GaAs n⁺, une couche collecteur 14 en GaAs n⁻, une couche formant base 16 en GaAs p⁺, une couche d'émetteur 18 en GaAlAs n et une couche de contact émetteur 20 en GaAs n⁺.

Comme illustré sur la figure 1 annexée, la technologie la plus employée pour traiter ces structures est la technologie dite double mesa. Cette technologie consiste à réaliser une première gravure en 22 pour contacter la couche de base 16, puis une deuxième gravure en 24 pour contacter la couche de contact collecteur 12. Des contacts ohmiques 30, 32 et 34 sont ensuite déposés sur les couches de contact emetteur 20, base 16 et contact collecteur 12.

Dans ce type de technologie, la jonction émetteur 18 - base 16 est exposée par la gravure 22, ce qui induit des courants de surface importants.

Pour améliorer les performances du composant, il est nécessaire d'autoaligner les contacts d'émetteur 30 et de base 32, voire de collecteur 34, et également de diminuer la taille du composant.

Or, en diminuant la taille du composant, on augmente le rapport entre la périphérie et la surface de la jonction émetteur 18 - base 16 et on rend encore plus critique le problème de recombinaison à la surface de la jonction émetteur 18 - base 16.

Ces courants de surface entraînent une diminution très importante du gain qui empêche l'utilisation du composant dans les meilleurs conditions.

On a déjà proposé de nombreuses solutions pour tenter de résoudre le problème ainsi posé.

Il a été montré par exemple dans les documents "Near-ideal transport in an AlGaAs/GaAs heterostructure bipolar transistor by Na2S-9H2O regrowth", R. Nottenburgh, C. Sandorff, D. Humphrey, T. Hollenbeck, R. Bhat, Appl. Phys. Lett., 52(3), janv. 1988 et "Suppression of the emitter size effect on the current gain of AlGaAs/GaAs HBT by utilizing (NH4)2Sx treatment", S. Shokata, H. Okada, H. Hayashi, Inst. Phys. Ser., 112, 1991, que l'exposition de la surface à des solutions de type Na₂S.9H₂O ou (NH₄)2Sₓ permettait de diminuer les recombinaisons de surface. Cependant, cette passivation pose de réels problèmes technologiques, tels que stabilité dans le temps, compatibilité avec les traitements technologiques ultérieurs...

On a proposé dans le document "Super-gain AlGaAs/GaAs heterojunction bipolar transistors using an emitter edge-thinning design", H.Lin, S.Lee, Appl. Phys. Lett., 47(8), 1985, de conserver à la surface de la base, une partie de la couche d'émetteur en GaAlAs et de ne l'enlever que sous les contacts ohmiques de base. L'inconvénient de cette technique est que d'une part l'épaisseur de la couche conservée n'est pas contrôlable et d'autre part que pour réaliser un contact ohmique de faible résistivité, il est nécessaire de dégager cette couche de GaAlAs. Cette technique est donc difficilement exploitable, en particulier dans le cas d'une technologie autoalignée.

On a proposé dans le document "Submicron scaling of AlGaAs/GaAs self-aligned thin emitter heterojunction bipolar transistors (SATE-HBT) with current gain independent of emitter area", R.J. Malik, L.M. Lunardi, R.W. Ryan, S.C. Shunk, M.D. Feuer, Electron. Lett.,25 (17), Aout 1989, d'utiliser une couche d'émetteur en GaAlAs très fine (15 nm) et de contacter la base avec un contact diffusant AuBe. Avec cette technique, le contact ohmique présente une forte résistivité. De plus, les impératifs concernant l'épaisseur de la couche d'émetteur induisent une réduction extrémement importante du gain, rendant cette structure guère utilisable. Cette technologie a d'ailleurs été abandonnée à la connaissance des inventeurs.

Le document EP-A-0 408 252 (correspondant au préambule de la revendication 11) décrit une structure similaire à celle du document précité, dans laquelle le contact d'émetteur comprend de préference une sous-couche graduelle, pour éviter un effet redresseur.

On a proposé dans le document EP-A-384 113 "Multilayer base Heterojunction Bipolar transistor", d'utiliser une base graduelle en Al ou directement une base formée de 2 couches successives, la couche supérieure étant une couche de GaAlAs de type p à faible concentration d'Al. Cette dernière structure pose un certain nombre de difficultés, notamment gravure non sélective entre GaAlAs 30 et 10%, contact de plus forte résistivité sur GaAlAs 10% que sur GaAs, moindre efficacité de la passivation avec la diminution du pourcentage d'Al, diminution de l'efficacité d'injection.

On a également proposé dans le document EP-A-387 010 "Heterojunction Bipolar Transistor", d'épitaxier localement une couche de GaAlAs à forte concentration d'Al sur la couche de base. Cette technique élimine les problèmes de gravure sélective mais pose par contre des difficultés en ce qui concerne la résistivité de contact et la reprise d'épitaxie.

Enfin on a proposé dans le document "High speed non self-aligned GaInP/GaAs TEBT", P.Zwicknagl, U. Schaper, L. Scleicher, H. Siweris, K. Bachem, T. Lauterbach, W. Pletschen, Electron. lett., 28 (3), 1992, de réaliser une couche d'émetteur formée de 2 couches l'une en GaAs et l'autre en GaInP. Cette solution utilise la sélectivité de gravure, ainsi que la passivation de la jonction émetteur-base par la couche de GaInP. Cependant d'une part cette structure dénommée "Tunneling Emitter Bipolar Transistor" (TEBT) présente des gains faibles du fait de l'utilisation d'un matériau présentant une largeur de bande interdite faible (petit gap) dans l'émetteur, et d'autre part l'utilisation du contact CrAu proposé dans cette publication ne permet pas de contacter la couche de base à travers le GaInP. Il est donc nécessaire d'éliminer le GaInP sous le contact de base. Cette technologie est donc difficilement adaptable aux transistors de petite dimension et aux transistors fabriqués avec une technologie autoalignée.

Le document S. Tiwari et al. : IEEE Transactions on Electron Devices, ED-34 (2), Fevrier 1987, pages 185-198, présente une étude des propriétés de transistors bipolaires à double hétérojonction à base de GaAs/GaAlAs. Ce document présente notamment sur sa figure 1 diverses structures de transistor. La figure 1b prévoit une implantation additionnelle dans une région de base extrinsèque pour réduire la résistance de base. Ce document est par ailleurs très éloigné de l'invention.

En conclusion, les solution proposées antérieurement présentent toutes des difficultés d'ordre technologique, en particulier problème de stabilité et de fiabilité dans le cas du dépôt de quelques monocouches passivantes, problème de gravure non sélective dans le cas de l'utilisation du matériau GaAlAs pour réaliser la passivation, problème de la réalisation de contact ohmique de type p de faible résistivité sur le GaAlAs, faible gain...

La présente invention a pour but de perfectionner les structures de transistor existantes en éliminant les inconvénients de la technique antérieure.

Plus précisément la présente invention a pour but de réaliser des transistors, en particulier des transistors bipolaires à hétérojonction, les plus performants possibles, en particulier présentant un fort gain intrinsèque par l'amélioration de l'efficacité d'injection, et conservant ce fort gain sur les transistors de petite dimension par élimination des courants de recombinaison de surface, avec un procédé très simple.

Ce but est atteint selon la présente invention grâce à un transistor du type défini en revendications 11 et 12 annexées.

Selon une autre caractéristique avantageuse de la présente invention, l'intervalle de bande interdite de la seconde couche est de préférence inférieur ou égal à celui de la première couche. Dans le cas d'un transistor npn, on choisira selon la présente invention un couple de matériau tel que : ΔEᵥ (GaAs/matériau 1)≥ΔEᵥ (GaAs/matériau 2) et ΔE_{c} (GaAs/matériau 1)≤ΔE_{c} (GaAs/matériau 2 ) . Pour un transistor pnp, on doit inverser les deux inégalités précédentes.

ΔEᵥ représente la discontinuité sur la bande de valence, tandis que ΔE_{c} représente la discontinuité sur la bande de conduction.

La présente invention concerne également un procédé de réalisation d'un tel transistor. Ce procédé est défini dans les revendications annexées.

D'autres caractéristiques, buts et avantages de la présente invention apparaitront à la lecture de la description détaillée qui va suivre et en regard des dessins annexés, donnés à titre d'exemple non limitatif et sur lesquels :
- la figure 1 annexée précédemment décrite représente schématiquement en coupe la structure d'un transistor bipolaire à hétérojonction conforme à l'état de la technique et
- la figure 2 annexée représente schématiquement en coupe la structure d'un transistor conforme à la présente invention.

La description détaillée qui va suivre d'un mode de réalisation particulier d'un transistor bipolaire à hétérojonction conforme à la présente invention concerne une mise en oeuvre utilisant les matériaux GaAs, GaAlAs et GaInP. Cependant d'autres matériaux peuvent être utilisés pour obtenir le même effet. Les valeurs des épaisseurs et dopages sont indiquées à titre indicatif.

On aperçoit sur la figure 2 annexée un transistor bipolaire à hétérojonction conforme à la présente invention comprenant :
- un substrat 100 semiconducteur III-V, par exemple de GaAs de type semi-isolant ou conducteur (n ou p);
- une première couche 110 en GaAs épitaxiée sur le substrat 100; la première couche 110 présente une conductivité d'un premier type et est fortement dopée dans la gamme 10¹⁸cm⁻³; elle forme la couche de contact collecteur ; son épaisseur est dans la gamme de 0,5-1µm;
- une seconde couche 120 en GaAs, GaAlAs ou GaInP épitaxiée sur la première couche 110; la seconde couche 120 de conductivité du premier type est faiblement dopée (dans la gamme 10¹⁶cm⁻³); elle forme la couche de collecteur ; son épaisseur est dans la gamme 0,5-1,5µm;
- une troisième couche 130 très fortement dopée (dans la gamme 10¹⁹-10²⁰cm⁻³ du deuxième type déposée sur la seconde couche 120, pour former la couche de base; la couche de base 130 possède un petit intervalle de bande interdite; elle est réalisée typiquement en GaAs. Cette couche peut présenter une variation de la bande interdite par l'introduction graduelle d'Al ou d'In. Son épaisseur est comprise dans la gamme 10-200nm ;
- une quatrième couche 140 faiblement dopée (dans la gamme 10¹⁶-10¹⁷cm⁻³) du premier type déposée sur la troisième couche 130; la quatrième couche 140 est réalisée en un matériau différent de la troisième couche 130, par exemple à l'aide de GaInP; elle possède un grand intervalle de bande interdite X2; la quatrième couche possède une faible épaisseur, typiquement comprise entre 10 et 60 nm, préférentiellement entre 20 et 45 nm, très avantageusement de l'ordre de 30 nm;
- une cinquième couche 150 faiblement dopée (dans la gamme 10¹⁶-10¹⁷cm⁻³) du premier type déposée sur la quatrième couche 140; la couche 150 possède un grand intervalle de bande interdite X3 de préférence inférieur ou égal à l'intervalle de bande interdite X2 de la quatrième couche 140; elle est réalisée en un matériau différent de la quatrième couche 140, typiquement en Ga₁₋ ₓAlₓAs avec par exemple x égal à 30% ; son épaisseur est dans la gamme 10-50nm ; les quatrième et cinquième couches 140 et 150 forment en combinaison l'émetteur;
- une sixième couche 160 en GaAs ou GaInAs du premier type fortement dopée (dans la gamme 10¹⁸-10¹⁹cm⁻³) est ensuite déposée sur la cinquième couche 150 pour former la couche de contact d'émetteur. Son épaisseur est dans la gamme 10-20 nm.

Dans le cadre de la présente demande de brevet, on entend par "grand intervalle de bande interdite" un intervalle supérieur à celui de la couche de base 130 sous-jacente. A titre d'exemple pour une couche de base en GaAs possédant un intervalle de bande interdite de 1,42 eV, on peut utiliser pour la couche 140 du GaInP ayant un intervalle de bande interdite de 1,84 eV et pour la couche 150 du GaAlAs ayant un intervalle de bande interdite de 1,79 eV.

En variante, le substrat 100 peut être formé de Si ou InP, sous réserve de prévoir alors en intermédiaire une couche tampon.

Pour réaliser les deux couches 140 et 150 composant l'émetteur dans le cas d'un transistor npn, on peut retenir par exemple les associations suivantes :
GaAlAs(150)-GaInP(140), GaAlAs ou GaInP (150)-GaP(140), AlInAs(150)-InP(140).

Inversement pour réaliser un transistor pnp, les deux couches 140 et 150 composant l'émetteur peuvent être choisies dans le groupe suivant :
GaAlAs (140)-GaInP(150), GaAlAs ou GaInP (140)-GaP(150), AlInAs (140)-InP (150).

Une première gravure 200 est opérée pour exposer la couche de GaInP 140 formant l'émetteur. Cette étape est réalisée grâce à une solution de gravure sélective entre le matériau GaAlAs composant la couche 150 et le matériau GaInP composant la couche 140. On peut pour cette opération utiliser par exemple les agents chimiques H₃PO₄-H₂O₂-H₂O dans les proportions 3-1-40.

La première gravure est donc naturellement arrêtée à la surface de la couche d'émetteur 140 en GaInP.

Une deuxième gravure 210 est ensuite réalisée pour atteindre la couche de contact collecteur 110.

L'isolation des composants est ensuite effectuée. Cette isolation peut également être réalisée en première étape. Puis on dépose l'électrode d'émetteur 220 et l'électrode de collecteur 230. Ce dépôt est suivi du recuit des contacts 220 et 230.

L'électrode de base 240 du deuxième type est ensuite directement déposée sur la couche d'émetteur 140 en GaInP. Le dépôt du contact 240 est suivi d'un recuit.

Le contact ohmique 240 a pour but de contacter la couche de base 130 à travers la couche de GaInP 140 formant l'émetteur. Elle doit présenter une faible résistivité.

A cet effet le contact de base 240 peut être réalisé par exemple sous forme d'un contact diffusant, tel que en AuMn. L'utilisation d'un tel contact diffusant permet de contacter la couche de base à travers la couche de GaInP 140 et permet de laisser la couche de passivation sur toute la surface de la base extrinsèque 130 du composant.

La présente invention permet d'obtenir grâce à la même couche d'émetteur 140 une gravure sélective, et la passivation de la couche de base 130, tout en augmentant l'efficacité de l'injection.

Cette nouvelle structure conforme à la présente invention permet donc d'obtenir conjointement une technologie de fabrication simple et une amélioration des performances par l'élimination de l'effet de réduction du gain sur des petites géométries dû aux recombinaisons de surface et par l'amélioration de l'efficacité d'injection.

La présente invention permet d'obtenir des gains très élevés, par exemple un gain de 300 pour une couche de base 130 présentant une épaisseur de 50nm et un dopage de 5.10¹⁹ cm⁻³.

Par ailleurs l'utilisation du matériau GaInP pour réaliser la couche d'émetteur 140 permet d'obtenir une plus faible résistivité pour le contact qui traverse cette couche pour contacter la base, que l'utilisation du matériau GaAlAs.

La présente invention s'applique aux transistors npn ou pnp.

La présente invention s'applique également dans le système InP. Dans le cas d'un transistor npn, la couche 110 est alors en GaInAs ; la couche 120 en GaInAs, AlInAs ou Inp ; la couche 130 en GaInAs ; la couche 140 en InP ; la couche 150 en AlInAs et la couche 160 en InGaAs.

Dans le cas d'un transistor pnp, la nature des couches 140 et 150 est inversée : la couche 140 est en AlInAs et la couche 150 est en InP.

La présente invention permet de réaliser des transistors en technologie classique double mesa (comme précédemment décrit), mais aussi en technologie auto-alignée. La technologie auto-alignée permet d'obtenir un contact émetteur très proche du contact de base et de réaliser ceux-ci à l'aide d'un même niveau de gravure. Dans ce dernier cas, on peut après la gravure de la couche 150 réaliser l'auto-alignement des contacts d'émetteur et de base avec des espaceurs en diélectrique ou utiliser la sous gravure des couches 150 et/ou 160 pour auto-aligner le contact de base par rapport au contact d'émetteur.

L'invention s'applique principalement dans le domaine de la micro-électronique et de la micro-optoélectronique.

L'invention s'applique tout particulièrement à la réalisation de transistors bipolaires à simple ou double hétérojonction, notamment sur substrat de GaAs ou d'InP, et aux circuits associés. Cependant la présente invention, plus précisément l'excellente sélectivité de la gravure entre le GaInP et le GaAs ou le GaAlAs, peuvent également s'appliquer à la réalisation de structures de transistors à effet de champ, telles que MESFET, HFET, HMET ...et dans les circuits réalisés avec ces dispositifs, en remplacement par exemple du couple classique GaAlAs/AlAs qui présente des difficultés d'ordre technologique.

Outre les avantages précités résultant de la structure conforme à la présente invention, les inventeurs ont constaté que la première couche 140 d'émetteur en GaInP permet d'éviter la diffusion du dopant classique en bérylium de la base 130 sous-jacente. Ainsi, la structure conforme à la présente invention permet d'appliquer le dopant Be sur la base 130 à l'aide d'une épitaxie par jet moléculaire classique, et ne requiert pas l'utilisation de technique plus sophistiquée, développée de nos jours, afin d'appliquer un dopant carbone, afin d'éviter la diffusion du bérylium, constatée fréquemment sur les structures antérieures connues.

## Revendications

1. Procédé de réalisation d'un transistor bipolaire npn à hétérojonction, du type comprenant les étapes consistant à réaliser des couches (120, 130, 140, 150) formant collecteur présentant une conductivité d'un premier type, base présentant une conductivité de second type et émetteur présentant une conductivité de premier type, ainsi que des contacts ohmiques (220, 230, 240) de collecteur, de base et d'émetteur, l'émetteur comprenant une couche fine (140) en un matériau à grand intervalle de bande interdite, supérieur à celui de la couche de base (130) sous-jacente, le contact ohmique de base (240) étant déposé sur cette première couche fine (140) composant l'émetteur, l'étape de réalisation de l'émetteur consistant à déposer deux couches superposées composant l'émetteur, sur la couche de base (130) : la première couche fine (140) formée d'un premier matériau, sur laquelle est déposé le contact ohmique de base (240) et une deuxième couche (150) formée d'un deuxième matériau différent du premier et possédant également un intervalle de bande interdite supérieur à celui de la couche de base (130), laquelle deuxième couche est déposée sur la première (140), caractérisé par le fait que la discontinuité sur la bande de valence entre GaAs et le matériau de la première couche fine (140) est supérieure à la discontinuité sur la bande de valence entre GaAs et le matériau de la deuxième couche (150), tandis que la discontinuité sur la bande de conduction entre GaAs et le matériau de la première couche fine (140) est inférieure à la discontinuité sur la bande de conduction entre GaAs et le matériau de la deuxième couche (150).

2. Procédé de réalisation d'un transistor bipolaire pnp à hétérojonction, du type comprenant les étapes consistant à réaliser des couches (120, 130, 140, 150) formant collecteur présentant une conductivité d'un premier type, base présentant une conductivité de second type et émetteur présentant une conductivité de premier type, ainsi que des contacts ohmiques (220, 230, 240) de collecteur, de base et d'émetteur, l'émetteur comprenant une couche fine (140) en un matériau à grand intervalle de bande interdite, supérieur à celui de la couche de base (130) sous-jacente, le contact ohmique de base (240) étant déposé sur cette première couche fine (140) composant l'émetteur, l'étape de réalisation de l'émetteur consistant à déposer deux couches superposées composant l'émetteur, sur la couche de base (130) ; la première couche fine (140) formée d'un premier matériau sur laquelle est déposé le contact ohmique de base (240) et une deuxième couche (150) formée d'un deuxième matériau différent du premier et possédant également un intervalle de bande interdite supérieur à celui de la couche de base (130), laquelle deuxième couche est déposée sur la première (140), caractérisé par le fait que la discontinuité sur la bande de valence entre GaAs et le matériau de la première couche fine (140) est inférieure à la discontinuité sur la bande de valence entre GaAs et le matériau de la deuxième couche (150), tandis que la discontinuité sur la bande de conduction entre GaAs et le matériau de la première couche fine (140) est supérieure à la discontinuité sur la bande de conduction entre GaAs et le matériau de la deuxième couche (150).

3. Procédé selon l'une des revendications 1 ou 2, caractérisé par le fait que l'intervalle de bande interdite de la deuxième couche (150) est inférieur ou égal à celui de la première couche (140).

4. Procédé selon l'une des revendications 1 à 3, caractérisé par le fait que la première couche (140) formant l'émetteur possède une résistance supérieure à un agent de gravure choisi que la deuxième couche (150) formant l'émetteur

5. Procédé selon la revendication 1, caractérisé par le fait que les matériaux composant les deux couches (140, 150) composant l'émetteur sont choisis parmi les couples suivants :
- GaInP pour la première couche (140) et GaAlAs pour la deuxième couche (150),
- GaP pour la première couche (140) et GaAlAs ou GaInP pour la deuxième couche (150),
- InP pour la première couche (140) et AlInAs pour la deuxième couche (150).

6. Procédé selon la revendication 2, caractérisé par le fait que les matériaux composant les deux couches (140, 150) composant l'émetteur sont choisis parmi les couples suivants :
- GaInP pour la deuxième couche (150) et GaAlAs pour la première couche (140),
- GaP pour la deuxième couche (150) et GaAlAs ou GaInP pour la première couche (140),
- InP pour la deuxième couche (150) et AlInAs pour la première couche (140).

7. Procédé selon l'une des revendications 1 à 6, caractérisé par le fait qu'il comprend en outre l'étape consistant à réaliser une étape de gravure jusqu'à la première couche (140) formant l'émetteur.

8. Procédé selon la revendication 7, caractérisé par le fait qu'il comprend en outre l'étape consistant à réaliser une seconde gravure afin d'exposer une couche de contact collecteur (110).

9. Procédé selon l'une des revendications 1 à 8, caractérisé par le fait qu'il comprend les étapes consistant à :
- déposer sur un substrat (100) une couche (110) de conductivité d'un premier type, fortement dopée, formant couche de contact collecteur,
- déposer sur la couche de contact collecteur (110) une couche (120) de conductivité du premier type, faiblement dopée, formant la couche de collecteur,
- déposer sur la couche de collecteur (120) une couche (130) très fortement dopée, du deuxième type de conductivité formant couche de base,
- déposer sur la couche de base (130) une couche (140) du premier type de conductivité, de faible épaisseur, en un premier matériau à grand intervalle de bande interdite, formant la première couche fine d'émetteur,
- déposer sur la première couche fine d'émetteur (140) une deuxième couche (150) du premier type de conductivité, formée d'un deuxième matériau possédant également un grand intervalle de bande interdite, et
- déposer sur la deuxième couche d'émetteur (150) une couche (160) du premier type de conductivité, fortement dopée, formant couche de contact d'émetteur.

10. Procédé selon la revendication 9, caractérisé par le fait qu'il comprend en outre les étapes consistant à déposer des contacts ohmiques de collecteur (230) et d'émetteur (220) respectivement sur la couche de contact collecteur (110) et sur la couche de contact d'émetteur (160).

11. Transistor bipolaire npn à hétérojonction comprenant des couches (120, 130, 140, 150) formant collecteur présentant une conductivité d'un premier type, base présentant une conductivité de second type et émetteur présentant une conductivité de premier type, et de contacts ohmiques (220, 230, 240) de collecteur, de base et d'émetteur, l'émetteur comprenant une première couche fine (140) en un matériau à grand intervalle de bande interdite, supérieur à celui de la couche de base (130) sous-jacente, le contact ohmique de base (240) étant déposé sur cette couche (140) composant l'émetteur, l'émetteur étant formé de deux couches superposées à la couche de base (130) : la première couche fine (140) formée d'un premier matériau, sur laquelle est déposé le contact ohmique de base (240), et une deuxième couche (150) formée d'un deuxième matériau différent du premier et possédant également un intervalle de bande interdite supérieur à celui de la couche de base (130), laquelle deuxième couche est déposée sur la première (140), caractérisé par le fait que la discontinuité sur la bande de valence entre GaAs et le matériau de la première couche (140) est supérieure à la discontinuité sur la bande de valence entre GaAs et le matériau de la deuxième couche (150), tandis que la discontinuité sur la bande de conduction entre GaAs et le matériau de la première couche (140) est inférieure à la discontinuité sur la bande de conduction entre GaAs et le matériau de la deuxième couche (150).

12. Transistor bipolaire pnp à hétérojonction comprenant des couches (120, 130, 140, 150) formant collecteur présentant une conductivité d'un premier type, base présentant une conductivité de second type et émetteur présentant une conductivité de premier type, et des contacts ohmiques (220, 230, 240) de collecteur, de base et d'émetteur, l'émetteur comprenant une première couche fine (140) en un matériau à grand intervalle de bande interdite, supérieur à celui de la couche de base (130) sous-jacente, le contact ohmique de base (240) étant déposé sur cette première couche (140) composant l'émetteur, l'émetteur étant formé de deux couches superposées à la couche de base (130) : la première couche fine (140) formée d'un premier matériau, sur laquelle est déposé le contact ohmique de base (240) et une deuxième couche (150) formée d'un deuxième matériau différent du premier et possédant également un intervalle de bande interdite supérieur à celui de la couche de base (130), laquelle deuxième couche est déposée sur la première (140), caractérisé par le fait que la discontinuité sur la bande de valence entre GaAs et le matériau de la première couche (140) est inférieure à la discontinuité sur la bande de valence entre GaAs et le matériau de la deuxième couche (150), tandis que la discontinuité sur la bande de conduction entre GaAs et le matériau de la première couche (140) est supérieure à la discontinuité sur la bande de conduction entre GaAs et le matériau de la deuxième couche (150).

13. Transistor selon l'une des revendications 11 ou 12, caractérisé par le fait que l'intervalle de bande interdite de la deuxième couche (150) est inférieur ou égal à celui de la première couche (140).

14. Transistor selon l'une des revendications 11 à 13, caractérisé par le fait que la première couche (140) formant l'émetteur possède une résistance supérieure à un agent de gravure choisi que la deuxième couche (150) formant l'émetteur.

15. Transistor selon la revendication 11, caractérisé par le fait que les matériaux composant les deux couches (140, 150) composant l'émetteur sont choisis parmi les couples suivants :
- GaInP pour la première couche (140) et GaAlAs pour la deuxième couche (150),
- GaP pour la première couche (140) et GaAlAs ou GaInP pour la deuxième couche (150),
- InP pour la première couche (140) et AlInAs pour la deuxième couche (150).

16. Transistor selon la revendication 12, caractérisé par le fait que les matériaux composant les deux couches (140, 150) composant l'émetteur sont choisis parmi les couples suivants :
- GaInP pour la deuxième couche (150) et GaAlAs pour la première couche (140),
- GaP pour la deuxième couche (150) et GaAlAs ou GaInP pour la première couche (140),
- InP pour la deuxième couche (150) et AlInAs pour la première couche (140).

17. Transistor selon l'une des revendications 11 à 16, caractérisé par le fait qu'il présente deux gravures exposant respectivement la première couche (140) formant l'émetteur et une couche de contact collecteur (110).

18. Transistor selon l'une des revendications 11 à 17, caractérisé par le fait qu'il comprend :
- sur un substrat (100) une couche (110) de conductivité d'un premier type, fortement dopée, formant couche de contact collecteur,
- sur la couche de contact collecteur (110) une couche (120) de conductivité du premier type de conductivité, faiblement dopée, formant la couche de collecteur,
- sur la couche de collecteur (120) une couche (130) très fortement dopée du deuxième type de conductivité, formant couche de base,
- sur la couche de base (130) une couche (140) du premier type de conductivité de faible épaisseur, en un premier matériau à grand intervalle de bande interdite, formant la première couche fine d'émetteur,
- sur la première couche fine d'émetteur (140) une deuxième couche (150) du premier type de conductivité formée d'un deuxième matériau possédant également un grand intervalle de bande interdite élevée, formant la deuxième couche d'émetteur, et
- sur la deuxième couche d'émetteur (150) une couche (160) du premier type de conductivité, fortement dopée, formant couche de contact d'émetteur.

19. Transistor selon l'une des revendications 11 à 18, caractérisé par le fait que l'épaisseur de la première couche fine (140) composant l'émetteur est comprise entre 10 et 60nm, de préférence entre 20 et 45nm, très avantageusement de l'ordre de 30nm.

20. Transistor selon l'une des revendications 11 à 19, caractérisé par le fait que la première couche fine (140) composant l'émetteur possède une concentration de dopage dans la gamme 10¹⁶-10¹⁷cm⁻³.

21. Transistor selon l'une des revendications 11 à 20, caractérisé par le fait que la deuxième couche (150) composant l'émetteur est formée de Ga₁₋ₓAlₓAs.

22. Transistor selon l'une des revendications 11 à 21, caractérisé par le fait que la première couche fine (140) composant l'émetteur est formée de GaInP.

23. Transistor selon l'une des revendications 11 à 22, caractérisé par le fait que la couche de collecteur (120) est réalisée en GaAs, GaAlAs ou GaInP.

24. Transistor selon l'une des revendications 11 à 23, caractérisé par le fait que la couche de base (130) est en GaAs, GaAlAs ou GaInAs.

25. Transistor selon l'une des revendications 11 à 24, caractérisé par le fait que des contacts ohmiques (220, 230) sont déposés respectivement sur les couches de contact émetteur (160) et de contact collecteur (110).

26. Transistor selon l'une des revendications 11 à 25, caractérisé par le fait que le contact ohmique de base (240) est un contact diffusant.

27. Transistor selon l'une des revendications 11 à 26, caractérisé par le fait que le contact ohmique de base (240) est réalisé en AuMn.

## Patentansprüche

1. Verfahren für die Herstellung eines bipolaren npn-Transistor mit Heteroübergang von einer Art, das die Schritte der Herstellung der den Kollektor bildenden Schichten (120, 130, 140, 150) umfaßt, die eine Leitfähigkeit einer ersten Art haben, sowie einer Basis mit einer Leitfähigkeit einer zweiten Art und eines Emitters mit einer Leitfähigkeit der ersten Art, sowie von ohmschen Widerständen (220, 230, 240) des Kollektors, der Basis und des Emitters, wobei der Emitter eine dünne Schicht (140) aus einem Material mit einem großen verbotenen Bandintervall aufweist, der über dem Intervall der darunterliegenden Basisschicht (130) liegt, und der ohmsche Widerstand (240) der Basis auf diese den Emitter bildende erste dünne Schicht (140) aufgetragen wird, wobei die Etappe der Herstellung des Emitters darin besteht, zwei den Emitter bildende übereinanderliegende Schichten auf die Basisschicht (130) aufzutragen, wobei die erste dünne Schicht (140) aus einem ersten Material gebildet wird, auf das der ohmsche Widerstand (240) der Basis aufgetragen wird, während die zweite Schicht (150) aus einem anderen Material als die erste Schicht hergestellt wird, das ebenfalls einen verbotenen Bandintervall besitzt, der über demjenigen der Basisschicht (130) liegt, und diese zweite Schicht auf die erste Schicht (140) aufgetragen wird,
**dadurch gekennzeichnet, daß**
die Diskontinuität auf dem Valenzband zwischen dem GaAs und dem Material der ersten dünnen Schicht (140) größer ist, als die Diskontinuität auf dem Valenzband zwischen dem GaAs und dem Material der zweiten Schicht (150), während die Diskontinuität auf dem Konduktionsband zwischen dem GaAs und dem Material der ersten dünnen Schicht (140) geringer ist, als die Diskontinuität auf dem Konduktionsband Zwischen dem GaAs und dem Material der zweiten Schicht (150).

2. Verfahren für die Herstellung eines bipolaren pnp-Transistor mit Heteroübergang von einer Art, das die Schritte der Herstellung der den Kollektor bildenden Schichten (120, 130, 140, 150) umfaßt, die eine Leitfähigkeit einer ersten Art haben, sowie einer Basis mit einer Leitfähigkeit einer zweiten Art und eines Emitters mit einer Leitfähigkeit der ersten Art, sowie von ohmschen Widerständen (220, 230, 240) des Kollektors, der Basis und des Emitters, wobei der Emitter eine dünne Schicht (140) aus einem Material mit einem großen verbotenen Bandintervall aufweist, der über dem Intervall der darunterliegenden Basisschicht (130) liegt, und der ohmsche Widerstand (240) der Basis auf diese den Emitter bildende erste dünne Schicht (140) aufgetragen wird, wobei die Etappe der Herstellung des Emitters darin besteht, zwei den Emitter bildende übereinanderliegende Schichten auf die Basisschicht (130) aufzutragen, wobei die erste dünne Schicht (140) aus einem ersten Material gebildet wird, auf das der ohmsche Widerstand (240) der Basis aufgetragen wird, während die zweite Schicht (150) aus einem zweiten anderen Material als die erste Schicht hergestellt wird, das ebenfalls einen verbotenen Bandintervall besitzt, der über demjenigen der Basisschicht (130) liegt, und diese zweite Schicht auf die erste Schicht (140) aufgetragen wird,
**dadurch gekennzeichnet, daß**
die Diskontinuität auf dem Valenzband zwischen dem GaAs und dem Material der ersten dünnen Schicht (140) niedriger ist, als die Diskontinuität auf dem Valenzband zwischen dem GaAs und dem Material der zweiten Schicht (150), während die Diskontinuität auf dem Konduktionsband zwischen dem GaAs und dem Material der ersten dünnen Schicht (140) größer ist, als die Diskontinuität auf dem Konduktionsband zwischen dem GaAs und dem Material der zweiten Schicht (150).

3. Verfahren nach einem der Ansprüche 1 oder 2,
**dadurch gekennzeichnet, daß**
der verbotene Bandintervall der zweiten Schicht (150) kleiner oder gleich dem Intervall der ersten Schicht (140) ist.

4. Verfahren nach einem der Ansprüche 1 bis 3,
**dadurch gekennzeichnet, daß**
die den Emitter bildende erste Schicht (140) eine Festigkeit besitzt, welche größer als die Festigkeit eines gewählten Ätzagens ist, das für die den Emitter bildende zweite Schicht verwendet wird.

5. Verfahren nach Anspruch 1,
**dadurch gekennzeichnet, daß**
die den Emitter bildenden Materialien der beiden Schichten (140, 150) aus den folgenden Materialpaarungen ausgewählt werden:
- GalnP für die erste Schicht (140) und GaAlAs für die zweite Schicht (150);
- GaP für die erste Schicht (140) und GaAlAs oder GalnP für die zweite Schicht (150);
- InP für die erste Schicht (140) und AllnAs für die zweite Schicht (150).

6. Verfahren nach Anspruch 2,
**dadurch gekennzeichnet, daß**
die Materialien der beiden den Emitter bildenden Schichten (140, 150) aus den folgenden Materialpaarungen ausgewählt werden:
- GalnP für die zweite Schicht (150) und GaAlAs für die erste Schicht (140);
- GaP für die zweite Schicht (150) und GaAlAs oder GalnP für die erste Schicht (140);
- InP für die zweite Schicht (150) und AllnAs für die erste Schicht (140).

7. Verfahren nach einem der Ansprüche 1 bis 6,
**dadurch gekennzeichnet, daß**
es weiterhin einen Arbeitsschritt umfaßt, der eine Ätzung bis zu der ersten den Emitter bildenden Schicht (140) umfaßt.

8. Verfahren nach Anspruch 7,
**dadurch gekennzeichnet, daß**
es weiterhin einen Arbeitsschritt umfaßt, in dem eine zweite Ätzung durchgeführt wird, um eine Kontaktschicht (110) des Kollektors freizulegen.

9. Verfahren nach einem der Ansprüche 1 bis 8,
**dadurch gekennzeichnet, daß**
es folgende Arbeitsschritte umfaßt:
- Auftrag auf ein Substrat (100) einer Schicht (110) mit einer Leitfähigkeit eines ersten Typs, die stark dotiert ist und die Kontaktschicht des Kollektors bildet;
- Auftrag auf die Kontaktschicht (110) des Kollektors einer Schicht (120) mit der Leitfähigkeit des ersten Typs, die schwach dotiert ist und die Kollektorschicht bildet;
- Auftrag auf die Kollektorschicht (120) einer sehr stark dotierten Schicht (130) mit der Leitfähigkeit des zweiten Typs, welche die Basisschicht bildet;
- Auftrag auf die Basisschicht (130) einer Schicht (140) mit der Leitfähigkeit des ersten Typs, die eine geringe Dicke hat und aus einem ersten Material mit einem großen verbotenen Bandintervall besteht und die erste dünne Schicht des Emitters bildet;
- Auftrag auf die erste dünne Schicht (140) des Emitters einer zweiten Schicht (150) mit der Leitfähigkeit des ersten Typs und aus einem Material hergestellt ist, das ebenfalls einen großen verbotenen Bandintervall besitzt; und
- Auftrag auf die zweite Schicht (150) des Emitters einer Schicht (160) mit der Leitfähigkeit des ersten Typs, die stark dotiert ist und die Kontaktschicht des Emitters bildet.

10. Verfahren nach Anspruch 9,
**dadurch gekennzeichnet, daß**
es weiterhin Arbeitsschritte umfaßt, die darin bestehen, daß ohmsche Widerstände des Kollektors (230) und des Emitters (220) jeweils auf die Kontaktschicht (110) des Kollektors und die Kontaktschicht (160) des Emitters aufgetragen werden.

11. Bipolarer npn-Transistor mit Heteroübergang, der die Schichten (120, 130, 140, 150) aufweist, welche den Kollektor mit einer Leitfähigkeit des ersten Typs bilden, sowie eine Basis mit einer Leitfähigkeit eines zweiten Typs und einen Emitter mit einer Leitfähigkeit des ersten Typs enthält, sowie mit ohmschen Widerständen (220, 230, 240) des Kollektors, der Basis und des Emitters ausgestattet ist, wobei der Emitter eine erste dünne Schicht (140) aus einem Material mit einem großen verbotenen Bandintervall aufweist, der größer ist, als derjenige der darunter liegenden Basisschicht (130), wobei der ohmsche Widerstand der Basisschicht (240) auf diese den Emitter bildende Schicht (140) aufgetragen wird, und der Emitter aus zwei über der Basisschicht (130) aufgetragenen Schichten gebildet wird: das heißt, einer ersten dünnen Schicht (140) aus einem ersten Material, auf die der ohmsche Widerstand (240) der Basis aufgetragen wird, und einer zweiten Schicht (150), welche aus einem anderen Material besteht, als die erste Schicht und ebenfalls einen verbotenen Bandintervall besitzt, welcher größer ist, als derjenige der Basisschicht (130), wobei diese zweite Schicht auf die erste Schicht aufgetragen wird,
**dadurch gekennzeichnet, daß**
die Diskontinuität auf dem Valenzband zwischen dem GaAs und dem Material der ersten Schicht (140) größer ist, als die Diskontinuität auf dem Valenzband zwischen dem GaAs und dem Material der zweiten Schicht (150) ist, während die Diskontinuität auf dem Konduktionsband zwischen dem GaAs und dem Material der ersten Schicht (140) kleiner ist, als die Diskontinuität auf dem Konduktionsband zwischen dem GaAs und dem Material der zweiten Schicht (150).

12. Bipolarer pnp-Transistor mit Heteroübergang, der die Schichten (120, 130, 140, 150) aufweist, welche den Kollektor mit einer Leitfähigkeit des ersten Typs bilden, sowie eine Basis mit einer Leitfähigkeit eines zweiten Typs und einen Emitter mit einer Leitfähigkeit des ersten Typs, sowie ohmsche Widerstände (220, 230, 240) des Kollektors, der Basis und des Emitters aufweist, wobei der Emitter eine erste dünne Schicht (140) aus einem Material mit einem großen verbotenen Bandintervall aufweist, welcher größer ist, als derjenige der darunter liegenden Basisschicht (130), wobei der ohmsche Widerstand (240) der Basisschicht auf diese den Emitter bildende erste Schicht (140) aufgetragen wird, und der Emitter aus zwei über die Basisschicht (130) gelegten Schichten gebildet wird: das heißt, einer ersten dünnen Schicht (140) aus einem ersten Material, auf die der ohmsche Widerstand (240) der Basis aufgetragen wird, und einer zweiten Schicht (150), welche aus einem anderen Material besteht, als die erste Schicht und ebenfalls einen verbotenen Bandintervall besitzt, welcher größer ist, als derjenige der Basisschicht (130), wobei diese zweite Schicht auf die erste Schicht aufgetragen wird,
**dadurch gekennzeichnet, daß**
die Diskontinuität auf dem Valenzband zwischen dem GaAs und dem Material der ersten Schicht (140) kleiner ist, als die Diskontinuität auf dem Valenzband zwischen dem GaAs und dem Material der zweiten Schicht (150), während die Diskontinuität auf dem Konduktionsband zwischen dem GaAs und dem Material der ersten Schicht (140) größer ist, als die Diskontinuität auf dem Konduktionsband zwischen dem GaAs und dem Material der zweiten Schicht (150).

13. Transistor nach einem der Ansprüche 11 oder 12,
**dadurch gekennzeichnet, daß**
der verbotene Bandintervall der zweiten Schicht (150) kleiner oder gleich demjenigen der ersten Schicht (140) ist.

14. Transistor nach einem der Ansprüche 11 bis 13,
**dadurch gekennzeichnet, daß**
die den Emitter bildende erste Schicht (140) eine Festigkeit besitzt, welche größer als diejenige eines gewählten Ätzagens ist, als die zweite den Emitter bildende Schicht (150).

15. Transistor nach Anspruch 11,
**dadurch gekennzeichnet, daß**
die Materialien der den Emitter bildenden Schichten (140, 150) aus den folgenden Materialpaarungen ausgewählt werden:
- GalnP für die erste Schicht (140) und GaAlAs für die zweite Schicht (150);
- GaP für die erste Schicht (140) und GaAlAs oder GalnP für die zweite Schicht (150);
- InP für die erste Schicht (140) AllnAs für die zweite Schicht (150).

16. Transistor nach Anspruch 12,
**dadurch gekennzeichnet, daß**
die Materialien der den Emitter bildenden beiden Schichten (140, 150) aus den folgenden Materialpaarungen ausgewählt werden:
- GalnP für die zweite Schicht (150) und GaAlAs für die erste Schicht (140);
- GaP für die zweite Schicht (150) und GaAlAs oder GalnP für die erste Schicht (140);
- InP für die zweite Schicht (150) und AllnAs für die erste Schicht (140).

17. Transistor nach einem der Ansprüche 11 bis 16,
**dadurch gekennzeichnet, daß**
er mit zwei Ätzungen behandelt wird, mit deren Hilfe die jeweils die den Emitter bildende erste Schicht (140), sowie eine den Kollektor bildende Kontaktschicht (110) freigelegt werden.

18. Transistor nach einem der Ansprüche 11 bis 17,
**dadurch gekennzeichnet, daß**
er folgendes umfaßt:
- auf einem Substrat (100) eine Schicht (110) mit einer Leitfähigkeit eines ersten Typs, die schwach dotiert ist und die Kollektorschicht bildet;
- auf der Kollektorschicht (110) eine Schicht (120) mit der Leitfähigkeit des ersten Typs, die schwach dotiert ist und die Kollektorschicht bildet;
- auf der Kollektorschicht (120) eine sehr stark dotierte Schicht (130) mit der Leitfähigkeit des ersten Typs, welche die Basisschicht bildet;
- auf der Basisschicht (130) eine Schicht'(140) mit der Leitfähigkeit des ersten Typs mit einer geringen Dicke, die aus einem Material mit einem großen verbotenen Bandintervall hergestellt ist und die erste dünne Schicht des Emitters bildet;
- auf der ersten dünnen Schicht (140) des Emitters eine zweite Schicht (150) mit der Leitfähigkeit des ersten Typs, welche aus einem zweiten Material hergestellt ist, das ebenfalls einen großen verbotenen Bandintervall besitzt und die zweite Schicht des Emitters bildet; und
- auf der zweiten Schicht (150) des Emitters eine Schicht (160) mit der Leitfähigkeit des ersten Typs, die stark dotiert ist und die Kontaktschicht des Emitters bildet.

19. Transistor nach einem der Ansprüche 11 bis 18,
**dadurch gekennzeichnet, daß**
die Dicke der den Emitter bildenden ersten dünnen Schicht (140) zwischen 10 und 60 nm liegt, und vorzugsweise zwischen 20 und 45 nm, und noch bevorzugter eine Größenordnung von 30 nm hat.

20. Transistor nach einem der Ansprüche 11 bis 19,
**dadurch gekennzeichnet, daß**
die den Emitter bildende erste Schicht (140) eine Konzentration der Dotierung im Bereich von 10¹⁶ -10¹⁷ cm³ besitzt.

21. Transistor nach einem der Ansprüche 11 bis 20,
**dadurch gekennzeichnet, daß**
die den Emitter bildende zweite Schicht (150) aus Ga₁₋ₓAlₓAs besteht.

22. Transistor nach einem der Ansprüche 11 bis 21,
**dadurch gekennzeichnet, daß**
die den Emitter bildende erste dünne Schicht (140) aus GalnP hergestellt ist.

23. Transistor nach einem der Ansprüche 11 bis 22,
**dadurch gekennzeichnet, daß**
die Kollektorschicht (120) aus GaAs, GaAlAs oder GalnP hergestellt ist.

24. Transistor nach einem der Ansprüche 11 bis 23,
**dadurch gekennzeichnet, daß**
die Basisschicht (130) aus GaAs, GalAs oder GalnAs besteht.

25. Transistor nach einem der Ansprüche 11 bis 24,
**dadurch gekennzeichnet, daß**
die ohmschen Widerstände (220, 230) jeweils auf die Kontaktschicht (160) des Emitters und die Kontaktschicht (110) des Kollektors aufgetragen werden.

26. Transistor nach einem der Ansprüche 11 bis 25,
**dadurch gekennzeichnet, daß**
der ohmsche Widerstand (240) der Basis ein Diffusionskontakt ist.

27. Transistor nach einem der Ansprüche 11 bis 26,
**dadurch gekennzeichnet, daß**
der ohmsche Widerstand (240) der Basis aus AuMn hergestellt ist.

## Claims

1. Process for producing a heterojunction npn bipolar transistor, of the type comprising the steps consisting in producing layers (120, 130, 140, 150) forming a collector having a conductivity of a first type, a base having a conductivity of a second type and an emitter having a conductivity of a first type, as well as ohmic contacts (220, 230, 240) for the collector, base and emitter, the emitter comprising a thin layer (140), of a material having a wide band gap, greater than that of the subjacent base layer (130), the ohmic base contact (240) being deposited on this first thin layer (140) of which the emitter is composed, the step of producing the emitter consisting in depositing two superimposed layers of which the emitter is composed on the base layer (130); the first thin layer (140) formed from a first material, on which the ohmic base contact (240) is deposited, and a second layer (150) formed from a second material differing from the first and also having a band gap greater than than of the base layer (130), which second layer is deposited on the first (140), characterized in that the discontinuity in the valence band between GaAs and the material of the thin first layer (140) is greater than the discontinuity in the valence band between GaAs and the material of the second layer (150), while the discontinuity in the conduction band between GaAs and the material of the first thin layer (140) is less than the discontinuity in the conduction band between GaAs and the material of the second layer (150).

2. Process for producing a heterojunction pnp bipolar transistor, of a type comprising the steps consisting in producing layers (120, 130, 140, 150) forming a collector having a conductivity of a first type, a base having a conductivity of a second type and an emitter having a conductivity of a first type, as well as ohmic contacts (220, 230, 240) of the collector, base and emitter, the emitter comprising a thin layer (140) of a material having a wide band gap, greater than that of the subjacent base layer (130), the ohmic base contact (240) being deposited on this first thin layer (140) of which the emitter is composed, the step of producing the emitter consisting in depositing two superimposed layers of which the emitter is composed on the base layer (130); the first thin layer (140) formed from a first material, on which the ohmic base contact (240) is deposited, and a second layer (150) formed from a second material differing from the first and also having a band gap greater than that of the base layer (130), which second layer is deposited on the first (140), characterized in that the discontinuity in the valence band between Gas and the material of the first thin layer (140) is less than the discontinuity in the valence band between the GaAs and the material of the second layer (150), while the discontinuity in the conduction bend between GaAs and the material of the first thin layer (140) is greater than the discontinuity in the conduction band between GaAs and the material of the second layer (150).

3. Process according to either of Claims 1 and 2, characterized in that the band gap of the second layer (150) is less than or equal to that of the first layer (140).

4. Process according to one of Claims 1 to 3, characterized in that the first layer (140) forming the emitter has a greater resistance to a chosen etching agent than the second layer (150) forming the emitter.

5. Process according to Claim 1, characterized in that the materials making up the two layers (140, 150) of which the emitter is composed are chosen from the following pairs:
- GaInP in the case of the first layer (140 and GaAlAs in the case of the second Layer (150),
- GaP in the case of the first layer (140) and GaAlAs or GaInP in the case of the second layer (150),
- InP in the case of the first layer (140) and AlInAs in the case of the second layer (150).

6. Process according to Claim 2, characterized in that the materials making up the two layers (140, 150) of which the emitter is composed are chosen from the following pairs:
- GaInP in the case of the second layer (150) and GaAlAs in the case of the first layer (140),
- GaP in the case of the second layer (150) and GaAlAs or GaInP in the case of the first layer (140),
- InP in the case of the second layer (150) and AlInAs in the case of the first layer (140).

7. Process according to one of Claims 1 to 6, characterized in that it furthermore comprises the step consisting in carrying out a step of etching down to the first layer (140) forming the emitter.

8. Process according to Claim 7, characterized in that it furthermore comprises the step consisting in carrying out a second etching operation so as to expose a collector contact layer (110).

9. Process according to one of Claims 1 to 8, characterized in that it comprises the steps consisting in:
- depositing, on a substrate (100), a highly doped layer (110) of conductivity of a first type, forming a collector contact layer,
- depositing, on the collector contact layer (110), a lightly doped layer (120) of conductivity of the first type, forming the collector layer,
- depositing, on the collector layer (120), a very highly doped layer (130) of the second conductivity type, forming a base layer,
- depositing, on the base layer (130), a thin layer (140) of the first conductivity type made of a first material having a wide band gap, forming the first thin layer of the emitter,
- depositing on the first thin layer (140) of the emitter, a second layer (150) of the first conductivity type, formed from a second material also having a wide band gap, and
- depositing, on the second emitter layer (150), a highly doped layer (160) of the first conductivity type, forming an emitter contact layer.

10. Process according to Claim 9, characterized in that it furthermore comprises the steps consisting in depositing a collector ohmic contact (230) and an emitter comic contact (220), respectively on the collector contact layer (110) and on the emitter contact layer (160).

11. Heterojunction npn bipolar transistor, of the type comprising layers (120, 130, 140, 150) forming a collector having a conductivity of a first type, a base having a conductivity of a second type and an emitter having a conductivity of a first type, as well as ohmic contacts (220, 230, 240) for the collector, base and emitter, the emitter comprising a first thin layer (140), of a material having a wide band gap, greater than that of the subjacent base layer (130), the ohmic base contact (240) being deposited on this layer (140) of which the emitter is composed, the emitter being formed by two superimposed layers on the base layer (130); the first thin layer (140) formed from a first material, on which the ohmic base contact (240) is deposited, and a second layer (150) formed from a second material differing from the first and also having a band gap greater than that of the base layer (130), which second layer is deposited on the first (140), characterized in that the discontinuity in the valence band between GaAs and the material of the first layer (140) is greater than the discontinuity in the valence band between GaAs and the material of the second layer (150), while the discontinuity in the conduction band between GaAs and the material of the first layer (140) is less than the discontinuity in the conduction band between GaAs and the material of the second layer (150).

12. Heterojunction pnp bipolar transistor, of a type comprising layers of (120, 130, 140, 150) forming a collector having a conductivity of a first type, a base having a conductivity of a second type and an emitter having a conductivity of a first type, as well as ohmic contacts (220, 230, 240) of the collector, base and emitter, the emitter comprising a first thin layer (140) of a material having a wide band gap, greater than that of the subjacent base layer (130), the ohmic base contact (240) being deposited on this first layer (140) of which the emitter is composed, the emitter being formed by two superimposed layers on the base layer (130); the first thin layer (140) formed from a first material, on which the ohmic base contact (240) is deposited, and a second layer (150) formed from a second material differing from the first and also having a band gap greater than that of the base layer (130), which second layer is deposited on the first (140), characterized in that the discontinuity in the valence band between GaAs and the material of the first layer (140) is less than the discontinuity in the valence band between the GaAs and the material of the second layer (150), while the discontinuity in the conduction band between GaAs and the material of the first layer (140) is greater than the discontinuity in the conduction band between GaAs and the material of the second layer (150).

13. Transistor according to either of Claims 11 and 12, characterized in that the band gap of the second layer (150) is less than or equal to that of the first layer (140).

14. Transistor according to one of Claims 11 to 13, characterized in that the first layer (140) forming the emitter has a greater resistance to a chosen etching agent than the second layer (150) forming the emitter.

15. Transistor according to Claim 11, characterized in that the materials making up the two layers (140, 150) of which the emitter is composed are chosen from the following pairs:
- GaInP in the case of the first layer (140) and GaAlAs in the case of the second layer (150),
- GaP in the case of the first layer (140) and GaAlAs or GaInP in the case of the second layer (150),
- InP in the case of the first layer (140) and AlInAs in the case of the second layer (150).

16. Transistor according to Claim 12, characterized in that the materials making up the two layers (140, 150) of which the emitter is composed are chosen from the following pairs:
- GaInP in the case of the second layer (150) and GaAlAs in the case of the first layer (140),
- GaP in the case of the second layer (150) and GaAlAs or GaInP in the case of the first layer (140),
- InP in the case of the second layer (150) and AlInAs in the case of the first layer (140).

17. Transistor according to one of Claims 11 to 16, characterized in that it has two etched regions exposing, respectively, the first layer (140) forming the emitter and a collector contact layer (110).

18. Transistor according to one of Claims 11 to 17, characterized in that it comprises:
- on a substrate (100), a highly doped layer (110) of conductivity of a first type, forming a collector contact layer,
- on the collector contact layer (110), a lightly doped layer (120) of the first conductivity type, forming the collector layer,
- on the collector layer (120), a very highly doped layer (130), of the second conductivity type, forming a base layer,
- on the base layer (130), a thin layer (140) of the first conductivity type, made of a first material having a wide band gap, forming the first thin layer of the emitter,
- on the first thin layer (140) of the emitter, a second layer (150) of the first conductivity type, formed from a second material also having a wide band gap, forming the second layer of the emitter and
- on the second emitter layer (150), a highly doped layer (160) of the first conductivity type, forming an emitter contact layer.

19. Transistor according to one of Claims 11 to 18, characterized in that the thickness of the first thin layer (140) of which the emitter is composed is between 10 and 60 nm, preferably between 20 and 45 mm and very advantageously about 30 nm.

20. Transistor according to one of Claims 11 to 19, characterized in that the first thin layer (140) of which the emitter is composed has a doping concentration in the 10¹⁶ - 10¹⁷ cm⁻³ range.

21. Transistor according to one of Claims 11 to 20, characterized in that the second layer (150) of which the emitter is composed is formed from Ga₁₋ₓAlₓAs.

22. Transistor according to one of Claims 11 to 21, characterized in that the first thin layer (140) of which the emitter is composed is formed from GaInP.

23. Transistor according to one of Claims 11 to 22, characterized in that the collector layer (120) is made of GaAs, GaAlAs or GaInP.

24. Transistor according to one of Claims 11 to 23, characterized in that the base layer (130) is made of Gals, GaAlAs or GaInAs.

25. Transistor according to one of Claims 11 to 24, characterized in that the ohmic contacts (220, 230) are deposited on the emitter contact layer (160) and the collector contact layer (110), respectively.

26. Transistor according to one of Claims 11 to 25, characterized in that the base ohmic contact (240) is a diffusing contact.

27. Transistor according to one of Claims 11 to 26, characterized in that the base ohmic contact (240) is made of AuMn.
